# EUROPEAN PATENT SPECIFICATION

(11) **EP 3 095 891 B1**
(45) Date of publication and mention of the grant of the patent: **09.06.2021**
(21) Application number: 15461578.5
(22) Date of filing: 29.11.2015
(51) Int. Cl.: C23C 14/20, C23C 14/56, D06M 11/83, D06M 10/02

(54) **METHOD FOR PREPARATION OF A COMPOSITE TEXTILE FABRIC WITH BIOACTIVE AND BARRIER PROPERTIES AGAINST ELECTROMAGNETIC FIELDS**
VERFAHREN ZUR HERSTELLUNG VON VERBUND-TEXTILMATERIAL MIT DEN MERKMALEN BIOAKTIV UND BARRIERE GEGENÜBER ELEKTROMAGNETISCHEN FELDERN
PROCÉDÉ DE PRÉPARATION D'UN MATÉRIAU TEXTILE COMPOSITE AYANT LES CARACTÉRISTIQUES BIOACTIF ET BARRIERE A DES CHAMPS ÉLECTROMAGNÉTIQUES

(30) Priority: 16.05.2015 PL 41234115
(43) Date of publication of application: 23.11.2016
(73) Proprietor: Siec Badawcza Lukasiewicz - Instytut Wlokiennictwa, 92-103 Lodz (PL)
(72) Inventor: Koprowska, Joanna, Lódz (PL); Wisniewski, Blazej, 91-736 Lódz (PL); Szwugier, Arkadiusz, 93-277 Lódz (PL)
(74) Representative: Witek, Rafal

(56) References cited:
- EP-A1- 2 476 766
- WO-A2-2013/115660
- JAN ZIAJA ET AL: "Metallic and oxide Zn and Ti layers on unwoven fabric as shields for electromagnetic fields", ELECTROMAGNETIC COMPATIBILITY - EMC EUROPE, 2009 INTERNATIONAL SYMPOSIUM ON, IEEE, PISCATAWAY, NJ, USA, 11 June 2009 (2009-06-11), pages 1-4, XP031499421, ISBN: 978-1-4244-4107-5

## Description

The object of the invention is a method for preparation of a composite textile fabric with bioactive and barrier properties against electromagnetic fields as well as the composite textile fabric with bioactive and barrier properties against electromagnetic fields intended for the use as different types of electromagnetic and bioactive barriers, *i.a.* filter materials.

Layer deposition in the magnetron sputtering method is known in the art and it is most often used on metal, ceramic or plastic substrates. Presently, the magnetron sputtering is most often used in electronic industry, in micro- and optoelectronics. It is also a subject of intensive research in order to develop cheap technologies which enable layer deposition on large glass surfaces. Due to many advantages of the magnetron sputtering method, new technological possibilities of obtaining thin layers with this method are investigated while using different substrates.

Metallic and oxide layers deposited on smooth surfaces (glass, ceramic substrates and polymer films) form solid and uniform structures. In such case, the value of screening efficiency SE results only from the process of electromagnetic wave reflection. However, for substrates of textile fabrics (with large specific surface area resulting from extended spatial structure) the screening layer is deposited not only on the surface, but it partially penetrates into inner layers of the textile fabric. In this case, the value of screening efficiency is increased by the dispersion effects at inner fibres.

The textile substrate is a specific type of plastic substrate due to the spacial structure which generally consists of very thin fibres. Thus, in case of the magnetron sputtering method, the concept of sputtered surface as well as layer thickness are difficult to define.

The international patent application WO2006030254 discloses a method for coating textile products by the deposition of metals: Ti, Ag or stainless steel and Ti-Ag mixture with ion sputtering method. A textile product can be the woven fabric, knitted fabric or non-woven fabric. Textile products are given antibacterial, deodorising, electroconductive, heat-screening and dirt-resistant properties. A method and a device for coating a substrate with a transparent layer of metal oxide by the magnetron sputtering method are disclosed in the German patent description No. DE102008034960. The method consists in that the substrate to be coated is shifted by a transport device through holes made in the device's chamber, wherein the substrate is coated by the magnetron sputtering with layers of tin, zinc, cadmium, gal, indium as well as compounds, particularly oxides, or mixtures of these materials. The device has a chamber equipped with a magnetron device, transport device for transporting the substrate to be coated and tubular cathodes.

The object of the Polish patent application (P.397977) is a textile product attenuating electromagnetic field and a device for preparation of the textile product suppressing electromagnetic field by coating textile products with coatings selected from the group comprising Zn, Cu, Al, Ti and Ag or at least one layer of alloy or metal mixture selected from the group comprising Ni-Fe, Zn-Bi, Bi-In, Cu-Sn and Cu-Zn, Cu-Zn-Ni or multilayer coating selected from the group comprising Zn-ZnO-Zn, Ti-TiO2-Ti, Zn-ZnO-Zn, Zn-TiO2-Zn and Ti-ZnO-Ti coated by the magnetron sputtering method, wherein textile products are intended for the use as electromagnetic shields, particularly in hospitals, office, apartment buildings and in laboratories, and they can be used for the production of wallpapers, draperies or curtains and blinds.

The substrate (P) of the textile product is coated with a coating comprising at least one layer (W1, W2, W3, W4) of metal and/or at least one layer (W1, W2, W3, W4) of metal oxide with thickness not exceeding single micrometres [µm], wherein layers (W1, W2, W3, W4) are applied to the substrate (P) alternately and the number of the layers applied (W1, W2, W3, W4) is determined by the shielding effectiveness of electromagnetic field by the textile product.

The European Patent Application EP 2 476 766 concerns the invention related to a method of producing antimicrobial material. Described was an antimicrobial raw material having antibacterial and corrosion-resistance properties, which can be directly formed as a film even on a plastic substrate with low heat-resistance or a substrate whereof the colour or properties are likely to change due to heat, and this can be achieved at relatively low cost. The antimicrobial raw material had a laminated structure which comprised a substrate layer and a copper-tin alloy layer disposed on the substrate layer and with a thickness ranging from 5 nm to 200 nm. The substrate layer was made of resin, natural fibber or paper, whereof the deflection temperature under load was 115°C or lower when measured in accordance with ASTM-D648-56 under a load of 1820 kPa. The substrate layer may be a film, nonwoven fabric or woven fabric. The copper-tin alloy layer contained over 60 atoms % but no more than 90 atom% of copper and 10 atoms % or more but less than 40 atom% of tin. There was no particular limitation on the method of forming the copper-tin alloy layer. As for physical and chemical deposition methods were exemplified. A scientific publication Ziaja J., Koprowska J., Janukiewicz J, "Using plasma metallisation for manufacture of textile screens against electromagnetic fields," Fibres&Textiles in Eastern Europe, 2008, vol. 16, No. 5, pages 64-66, discloses a method of the magnetron sputtering of Zn-Bi layer on the polypropylene non-woven fabric.

The main technical problem confronted by the present invention is to propose such a textile fabric which, due to the use as an air permeable electromagnetic and bioactive barrier, at the same time will have conductive, shielding electromagnetic field and antimicrobial properties as well as it will provide good air and water vapour permeability. It is desirable to obtain a textile fabric which meets the requirements set in the table below.

Desirable properties of the textile fabric according to the invention are given in the following table.

| No. | Parameter | Standard | Desirable Value |
|---|---|---|---|
| 1 | Antibacterial activity of textile fabrics (after modification) | ASTM E 2180-07 and AATCC Test Method 100: 2004 | According to JIS L 1902 Standard the product shows properties:-bacteriostatic, if S value is above 2-batericidal, if L value is not lower than 0, it is desirable to obtain at least bacteriostatic properties, preferably also bactericidal |
| | | *Staphylococcus aureus* (ATCC 6538) Gram (+) | |
| | | *Escherichia coli* (ATCC 11229) Gram (-) | |
| 2 | Antifungal activity of textile fabrics (after modifications) | Test procedure No. 8, 1st edition "Wyznaczanie aktywności antygrzybiczej. Ocena dzialania mikrogrzybów" according to PN - EN 14119 : 2005. Method B2. | The test result is considered positive if the growth of the tested microorganism is visible without magnifying devices, intensity to 50% of the tested surface (growth level ≤3 ) |
| 3 | Shielding Effectiveness SE, dB | ASTM D-4935-10 | >20 |
| 4 | Surface Resistance, R_{F},Ω | PN-EN-1149-1 | <100 |
| 5 | Air permeability, mm/s, at 200 Pa | PN-EN-ISO 9237:1998 | >200 |
| 6 | Water vapour resistance, Rₑₜ, m²Pa/W | PN-EN 31092:1998/Apl.2004 | <10 |

The major technical problem confronted by the present invention is to provide a method for preparation of such textile fabric, wherein this method should result in obtaining a fabric characterised by the above mentioned properties and applicable to the industrial use.

Surprisingly, the above mentioned technical problems have been solved by the present invention. The first subject of the invention is a method for preparation of a composite textile fabric with bioactive and barrier properties against electromagnetic fields, characterised in that:
a) the mechanically cleaned textile substrate is placed on the rolls in the working chamber, where the fabric is rewound from one roll to another, in the reverse method, travelling on the cylindrical anode being a cylindrical segment with a radius of 10 to 30 cm,
b) the textile substrate is cleaned with glow discharge,
c) the functional layer is sputtered in the magnetron sputtering method on the textile substrate travelling on the cylindrical anode at velocity of 5 mm/s to 50 mm/s, wherein as the textile substrate the thermoplastic non-woven fabric of polypropylene or other polyolefin fibres is used, while the functional layer is a metal selected from the group comprising: Cu, Cu/Sn, Cu/Zn/Ni, Zn, ZnO, Ni/Cu/Fe or combinations thereof, and the sputtering of the functional layer on the textile substrate in step c) is repeated in cycles of 5 to 50 times, wherein the magnetron sputtering is performed continuously at the travelling velocity of the textile substrate on the anode of 15 mm/s, and the pressure in the working chamber during the magnetron sputtering is within the range of 1.8 • 10⁻³ mbar to 4.0 • 10⁻³ mbar, and the magnetron sputtering is performed at the effective power ranging from 1.9 kW to 4.06 kW, and the magnetron sputtering is performed at the atmosphere of a working gas, preferably argon, batched to the working chamber at the amount of 3% to 8%, and the basis weight of the textile substrate is within the range of 50 g/m² to 180 g/m², and the fibres of the textile substrate have thickness within the range of 1,89 • 10⁻⁴ g/m to 3,89 • 10⁻⁴ g/m (1.7 den to 3.5 den), and wherein prior to step a), the textile substrate is calendered and/or spot-welded.

The second subject of the invention is a composite textile fabric with bioactive and barrier properties against electromagnetic fields, characterised in that it comprises the textile substrate with the functional layer of a thickness from a few to several dozen nanometres sputtered by the magnetron sputtering, wherein the textile substrate is the thermoplastic non-woven fabric of polypropylene or other polyolefin and the basis weight of the textile substrate is within the range of 50 g/m² to 180 g/m² and the fibres of the textile substrate have thickness within the range of 1,88 • 10⁻⁴ g/m to 3,88 • 10⁻⁴ g/m (1.7 den to 3.5 den), while the functional layer is a metal selected from the group comprising: Cu, Cu/Sn, Cu/Zn/Ni, Zn, ZnO, Ni/Cu/Fe or combinations thereof, wherein the said material shows bacteriostatic properties according to JIS L 1902 standard towards to two bacterial strains: Gram (-) *Escherichia coli and* Gram (+) *Staphylococcus aureus, measured according to ASTM E 2180-07 and AATCC Test Method 100: 2004,* and antifungal activity towards mould microfungi: *Chaetomium globosum, measured according to test procedure No. 8 of 1st edition of PN* - *EN 14119 : 2005 Standard method B2,* and shows the shielding effectiveness SE above 20 dB, measured according to ASTM D-4935-10 Standard, surface resistance below 100 Ω, measured according to PN-EN-1149-1 Standard, air permeability at 200 Pa above 200 mm/s, measured according to PN-EN-ISO 9237:1998 Standard, and water vapour resistance below 10 m²Pa/W, measured according to PN-EN 31092:1998/Apl.2004 Standard.

Preferably, the composite textile fabric according to the invention is obtained by the method according to the invention as defined above. Preferably, the composite textile fabric according to the invention is a calendered and/or spot-welded substrate.

The essence of the method for the preparation of textile composite according to the invention is that the substrate with a grid structure of regularly arranged thermoplastic polymer fibres is coated in the reverse method (roll-to-roll) by magnetron sputtering with a functional metallic component on separate fibres with thickness not exceeding single micrometres [µm], and the number of layers applied is determined by the desirable shielding effectiveness of electromagnetic field by the textile product and by antimicrobial activity.

The essence of the preparation of the functional composite fabric is that the textile fabric shifts continuously in a chamber of the device for magnetron sputtering under a target, on the surface of an anode with a shape of a partial cylinder which, by stretching the textile carrier strip, enables the exposition of its structure in the zone of magnetron sputtering of the metallic target located above the strip and the penetration of the metal particles into deeper areas of the textile fabric. The extension of the spatial structure depends on both starting material properties and the stress which results from winding the material around the cylindrical anode. The method of sputtering the metallic component is facilitated by the plasma frequency modulation which levels the electrification effect on the textile fabric surface, making it easier for sputtered target particles to penetrate deep into the fabric.

The above mentioned bi-composite, soft, with preserved textile product structure, consists of a textile component (substrate/carrier) and a functional component (metallic).

The result of the method according to the invention is the composite textile fabric with bioactive and barrier properties against electromagnetic fields, comprising the textile substrate with at least one functional layer of a thickness from a few to several dozen nanometres sputtered by repeated magnetron sputtering, wherein the textile substrate is the fabric of thermoplastic fibres, mainly polypropylene or other polyolefin, while the functional layer is the material selected from the group comprising: Cu, Cu/Sn, Cu/Zn/Ni, Zn, ZnO, Ni/Cu/Fe or combinations thereof.

The use of the thermoplastic material results in the formation of bonds between the substrate/carrier and functional component based not only on the van der Waals forces (0.01 eV), but also on chemical bonds of a different type (0-10 eV) giving improved adhesion of the functional component to the textile substrate, moreover, it provides conditions for improved conduction of electric charges, what results in the lower surface resistance of the applied metallic component, and, together with the structure, it gives the expected barrier effect against electromagnetic radiation. Particularly preferred effects are obtained, if:
- the textile substrate is a spunbond non-woven fabric (from under the spinneret);
- the non-woven fabric is made of 100% polypropylene with melt flow index of MFI 25 - 29;
- the basis weight of the non-woven fabric is: 50-180 g/m²;
- the distribution of fibres is uniform in the whole non-woven fabric and they occur in longitudinal and transverse direction at the ratio around 2:1, wherein this defines characteristic values of physico-mechanical properties;
- the non-woven fabric consists of very thin fibres whose thickness is within the range of 1.7-3.5 den what additionally increases the specific surface area of metal sputtering;
- the non-woven fabric is additionally calendered and spot-welded.

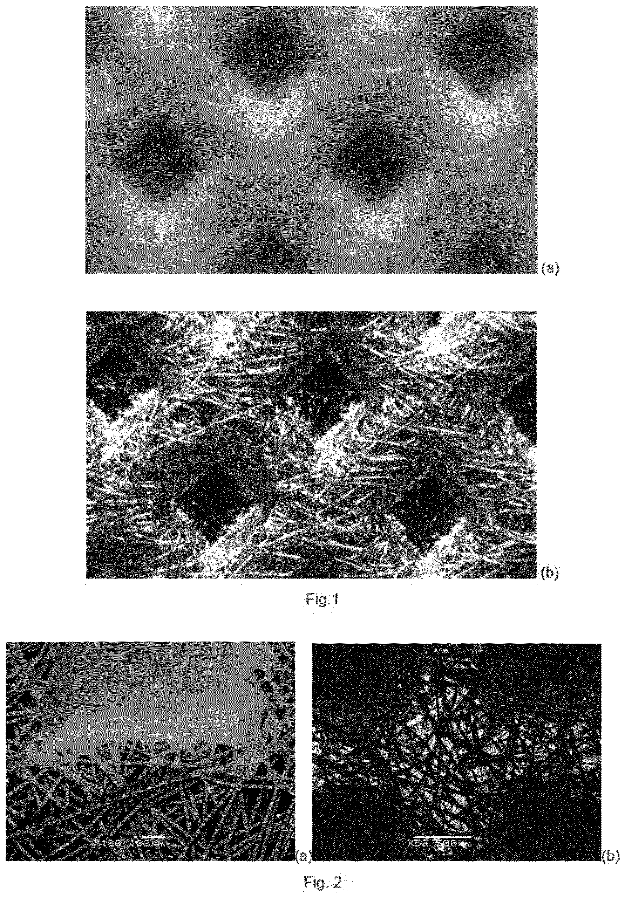

It is desirable that the textile substrate forms a stable structure advantageous for both the method course (no disturbances during rewinding) and barrier properties of the obtained composite. Due to the space grid structure, the textile substrate additionally provides the final composite with good air and water vapour permeability. By calendering, the non-woven fabric surface is pressed and the product gains stability. Spot-welding results in the specific structure of the non-woven fabric (Fig. 1). The Figure - (Fig. 1) shows the polypropylene textile carrier, wherein: a) is a view of the non-woven fabric surface before sputtering, b) is the non-woven fabric surface after metal sputtering (magnification 50x).

In concavities of non-woven fabric metal clusters are formed which enhance the shielding effect. On the other hand, on convex parts of non-woven fabric some "clearance" is left thanks to which the non-woven fabric is permeable for air and water vapour (Fig. 2).

The Figure - (Fig. 2) shows pictures of the non-woven fabric surface subjected to the treatment by the method according to the invention (a) - 100x, and (b) - 50x, wherein concavities filled with metal and the "clearance" surrounding them are visible.

Thanks to selection of suitable fabrics as the textile substrate and the functional layer and to provision of the suitable method of preparation, the composite textile fabric according to the invention has excellent bioactive and barrier properties against electromagnetic fields, while preserving good air and water vapour permeability.

Due to the use of the cylindrical anode in the magnetron sputtering system, together with continuous travelling at a certain linear velocity, the textile substrate is stretched on its surface and simultaneously the fabric structures are exposed in the sputtering zone. This enables the penetration of the functional material particles into deeper areas of the textile substrate.

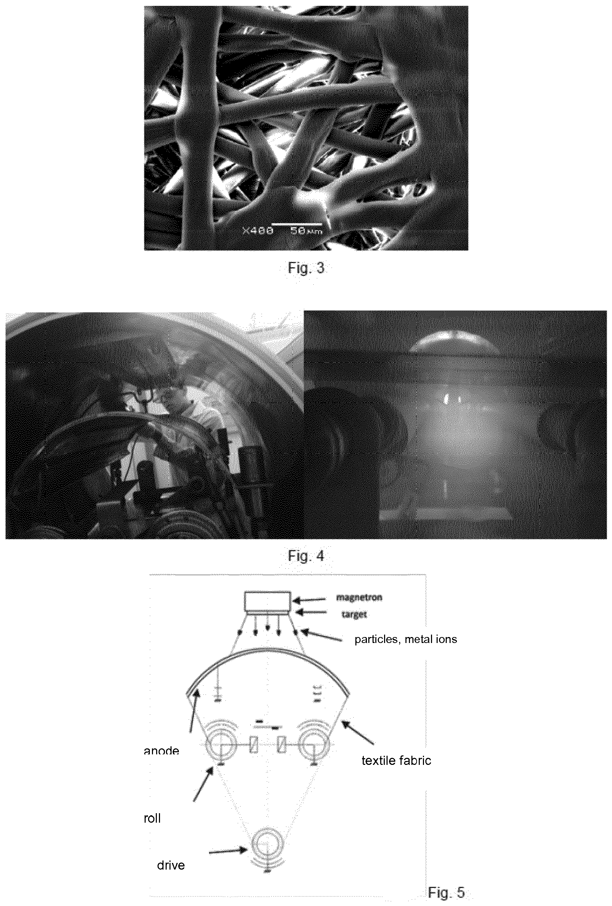

The Figure - (Fig. 3) shows a microscopic image (400x) of the non-woven fabric after the treatment by the method according to the invention, illustrating the penetration of metal into deeper areas of the non-woven fabric substrate.

The method of sputtering the metallic component is facilitated by the plasma frequency modulation which levels the electrification effect on the textile fabric surface, making it easier for sputtered target particles to penetrate deep into the fabric.

Sputtered functional layers are continuous on single fibres, they form a grid and show good adhesion to the substrate. The surface of textile substrate fibres during the magnetron sputtering is subjected to minimal partial melting, thereby a better binding between sputtered functional material particles and the substrate is obtained. Thanks to the reverse method of rewinding textile fabric from roll to roll and the control of its travelling velocity on the anode surface, it is possible to apply very subtle and at the same time even coatings whose thickness can be as small as a few to several dozen nanometres.

The number of layers applied is determined by the shielding effectiveness of electromagnetic field of the textile product and antimicrobial activity. Apart from the shielding properties against electromagnetic field, the composite fabric shows very good antibacterial properties due to the use of the coating of metals, alloys or combinations thereof, displaying simultaneously electroconductive, screening properties and the characteristic of antibacterial activity, as the material.

Antibacterial activity was tested with reference to two strains of bacteria: Gram (-) *Escherichia coli* and Gram (+) *Staphylococcus aureus.* The best results of antibacterial activity were obtained for the textile fabric - non-woven fabric of thermoplastic polymer - coated with: ZnO, Cu and Cu/Sn alloy. In tested coatings applied in the same conditions to other substrates (cotton woven fabric - bleached and unbleached, polyester-cotton woven fabric and polyester non-woven fabric) quite good antimicrobial activity was observed, which depended on the type of the coating applied, however, these composites, unfortunately, did not show shielding effectiveness of electromagnetic field.

Samples of the tested non-woven fabrics showed also the antifungal activity effect against the tested species of a mould *Chaetomium globosum,* which was tested according to the standard PN - EN 14119 : 2005. Method B2.

The main advantages of the composite barrier fabric according to the invention, apart from obtained functions are: lightness, good formability and, moreover, good air and water vapour permeability, which meet the requirements included in table 1. Construction solutions in the device, the impulse sputtering system used and accordingly selected method parameters enable to obtain the fabric with expected barrier properties which preserves - maintains the characteristics of a textile product. Embodiments of the invention are shown on photos, wherein: Fig. 1a) shows an image of the textile substrate at magnification, 1b) the substrate with the functional layer applied, Fig. 2 and Fig. 3 show the surface of the textile substrate with the functional layer applied, with its structure visible, while Fig. 4 presents photos of an inside view of the chamber with the cylinder shaped anode, (a) - open chamber and (b) - the inside of the chamber during the method according to the invention, and Fig. 5 is a scheme of the exemplary device to perform the method according to the invention.

The essence of the invention is illustrated by the following examples.

### Example 1

The method for preparation of the composite textile fabric with bioactive and barrier properties against electromagnetic fields according to the invention is performed according to the following steps:
1. Mechanical cleaning of the textile fabric before placing it in the working chamber - the removal of dust or other mechanical contaminants.
2. Placing the textile fabric on the rolls in the working chamber, where the fabric is rewound from one roll to another travelling on the cylindrical anode, preferably cooled with water.
3. Obtaining vacuum in the working chamber. The method of sputtering metals on textile fabrics is conducted at the established pressure ranging from 1.8 • 10⁻³ mbar to 4.0 • 10⁻³ mbar.
4. Glow discharge cleaning of the fabric surface with the magnetron head (glow discharge in the device's chamber).
5. After the glow discharge cleaning the method parameters are set, such as: travelling velocity of the textile carrier in the range of 5 mm/s to 50 mm/s, preferably 15 mm/s, amount of argon from 3% to 8%, preferably 4%. Also, the number of the run cycles is set which should be within the range of 5 to 50 cycles. Moreover, the magnetron feeder is set to the defined effective power of the method which should range from 1.9 kW to 4.06 kW. After its determination, the suitable power circulating (kW) also can be read. The screen shows the specific length of the sputtered fabric at a particular direction (m). During the sputtering, the fabric is rewound from one roll to another on the surface of the anode with a shape of a partial cylinder, placed below the target with sputtered metal. Fabric stresses resulting from winding it around the anode cause the deposition of the metal in deeper layers of the fabric.
6. After the sputtering process is finished, the chamber is aerated and the sputtered fabric is taken out from the device's chamber.
7. After the chamber is closed, the air in it is partially removed, so that it is left at low vacuum (around 10⁻¹ mbar).
8. Subsequently, the final step of the device's work and cooling the pump to the temperature of 70°C occur, so that the device automatically switches off.

### Example 2

The textile fabric (PP non-woven fabric 150 g/m²) was sputtered with Cu/Sn alloy showing bifunctional properties (antimicrobial and shielding electromagnetic field). Technological conditions of the sputtering method: p = 2.7 • 10⁻³ mbar, P_{ef} = 2.0-2.1 kW, P_{cyr} = 1.3-1.4 kW, amount of Ar = 4.0 %, V = 15 mm/s, number of run cycles = 15. For the obtained functional composite, very good shielding 35-41 dB and antimicrobial properties were achieved (see Table 1).

**Table 1**

| **Coating (Cu/Sn)** | | | | | | | | | |
|---|---|---|---|---|---|---|---|---|---|
| **The barrier effect of the composite against EMF at different frequencies** | | | | | | | | | |
| Frequency [MHz] | | 27.12 | | 97.75 | | 915 | 1795 | | |
| Shielding effectiveness [dB] | | 41 | 39 | | | 36 | 35 | | |

| **Antibacterial activity** | | | | | | | | | |
|---|---|---|---|---|---|---|---|---|---|
| **Name of the tested bacteria** (strain number) | | ***Staphylococcus aureus*** (ATCC 6538) Gram (+) | | | | ***Escherichia coli*** (ATCC 11229) Gram (-) | | | |
| Reduction in bacterial growth | | **99.99%** | | | | **99.99%** | | | |
| * Bactericidal activity value **L** | | **3.2** | | | | **3.2** | | | |
| Measurement method | | Luminescent method | | | | | | | |
| Time and temperature of incubation | | 21 h (37±2°C) | | | | | | | |

| **Antifungal activity** | | | | | | | | | |
|---|---|---|---|---|---|---|---|---|---|
| Name of the tested fungi (no. of the strain) | | *Chaetomium globosum* (ATCC 6205) | | | | | | | |
| | | Fungal growth evaluation | | | | | | | |
| | | Surface of samples | | | Surface of agar medium in contact zone with the sample | | | | |
| | Sample side | Growth level | Evaluation | | Inhibition zone width [mm] | | | Growth level | Evaluation |
| Sample side with coating | | | | A | 0 | Lack of visible growth, evaluated under the microscope (magnification 50x) | 0 | 0 | Lack of visible growth, evaluated under the microscope (magnificati on 50x) |
| Sample side without coating | | | | B | 0 | Lack of visible growth, evaluated under the microscope (magnification 50x) | 0 | 5 | Strong growth, of the same intensity as the control growth |

| Control sample - textile fabric without coating | | | | | | | | | |
|---|---|---|---|---|---|---|---|---|---|
| | | | | A | 2 | Growth visible without magnifying devices, covering to 25% of the control sample surface | 0 | 5 | Strong growth, covering the tested surface under the control sample completely |
| | | | | B | 4 | Significant growth, covering 60% of the control sample surface | 0 | 5 | Strong growth, covering the tested surface under the control sample completely |

### Example 3 (comparative)

Three different textile fabrics, including thermoplastic PP non-woven fabric (150 g/m²) were sputtered with copper Cu. Technological conditions of the method: p = 4.0-10⁻³ mbar, P_{ef} = 3.0 kW, V = 15 mm/s, amount of Ar = 4.0%, number of cycles = 10. Only thermoplastic PP non-woven fabric shows bifunctional properties.

**Table 2**

| Coating type | Copper coating (Cu) | | SE, dB |
|---|---|---|---|
| Substrate fabric | Unbleached cotton woven fabric | | |
| Name of the tested bacteria | *Staphylococcus aureus* (ATCC 6538) Gram (+) | *Escherichia coli* (ATCC 11229) Gram (-) | 0 |
| Bacteriostatic activity value **S** | **3.2** | 1.8 | |
| Bactericidal activity value **L** | **0.5** | -0.3 | |
| Substrate fabric | Polyester-cotton woven fabric | | |
| Bacteriostatic activity value **S** | **3.3** | **3.8** | |
| Bactericidal activity value **L** | **0.6** | 1.7 | |
| Substrate fabric | Polypropylene PP non-woven fabric (softening point 120-155°C) | | 20-30 |
| Reduction in bacterial growth % | **99.99** | **99.99** | |
| Bactericidal activity value **L** | **3.2** | **3.1** | |

### Example 4

Thermoplastic PP non-woven fabric 150 g/m² was sputtered with Cu/Sn (80/20) or Cu/Zn/Ni (55/27/18) alloy. Both alloys show good antibacterial properties. Technological conditions for both methods: p = 2.3-10⁻³ mbar, P_{ef}. = 2.1 kW, amount of Ar = 4.0%, travelling velocity 50 mm/s. The number of cycles was a variable parameter. 15, 30 or 40 cycles were applied. At higher number of cycles, higher SE values were obtained.

**Table 3**

| **Number of cycles** | **Shielding effectiveness of Cu/Sn coating [dB]** | | | | | **Average surface resistance [Ω]** |
|---|---|---|---|---|---|---|
| | **27.12 MHz** | **97.75 MHz** | **433.92 MHz** | **915 MHz** | **1795 MHz** | |
| 15 | 25 | 23 | 20 | 20 | 20 | 31.5 |
| 30 | 33 | 31 | 28 | 28 | 27 | 9.0 |
| 40 | 33 | 31 | 28 | 28 | 27 | 8.9 |

**Table 4**

| **Number of cycles** | **Shielding effectiveness of Cu/Zn/Ni coating [dB]** | | | | | **Average surface resistance [Ω]** |
|---|---|---|---|---|---|---|
| | **27.12 MHz** | **97.75 MHz** | **433.92 MHz** | **915 MHz** | **1795 MHz** | |
| 15 | 24 | 22 | 20 | 20 | 19 | 37.45 |
| 20 | 24 | 22 | 20 | 19 | 19 | 37.45 |
| 40 | 28 | 26 | 23 | 22 | 22 | 12.48 |

### Example 5

The thermoplastic PP non-woven fabric 150 g/m² was sputtered with Cu/Sn or Cu/Zn/Ni alloy showing bifunctional properties (antibacterial and shielding electromagnetic field). Technological conditions of both methods: p = 2.0-10⁻³ mbar, P_{ef} = 2.0 kW, amount of Ar = 4.0%, number of cycles 15. The travelling velocity of the textile carrier was a variable parameter and it was 15, 25 or 50 mm/s. The increase in the travelling velocity causes the decrease in shielding effectiveness.

**Table 5**

| **Velocity V [mm/s]** | **Shielding effectiveness of Cu/Sn coating [dB]** | | | | | **Average surface resistance [Ω]** |
|---|---|---|---|---|---|---|
| | **27.12 MHz** | **97.75 MHz** | **433.92 MHz** | **915 MHz** | **1795 MHz** | |
| 15 | 41 | 39 | 36 | 36 | 35 | 6.02 |
| 25 | 33 | 32 | 29 | 28 | 28 | 6.06 |
| 50 | 25 | 23 | 20 | 20 | 20 | 31.5 |

**Table 6**

| **Velocity V [mm/s]** | **Shielding effectiveness of Cu/Zn/Ni coating [dB]** | | | | | **Average surface resistance [Ω]** |
|---|---|---|---|---|---|---|
| | **27.12 MHz** | **97.75 MHz** | **433.92 MHz** | **915 MHz** | **1795 MHz** | |
| 15 | 38 | 36 | 33 | 33 | 32 | 5.35 |
| 25 | 31 | 29 | 26 | 26 | 25 | 12.48 |
| 50 | 24 | 22 | 20 | 20 | 19 | 37.45 |

### Example 6

The thermoplastic PP non-woven fabric 180 g/m² was sputtered with Cu/Sn or Cu/Zn/Ni alloy showing bifunctional properties (antibacterial and shielding electromagnetic field -). Technological conditions of the method : P = 2.0-10⁻³ mbar, amount of Ar = 4.0%, number of cycles 15. The effective power emitted on the target was a variable parameter and it was 2.0 kW and 4.0 kW. At higher effective power value, higher SE values were obtained.

**Table 7**

| **Effective power P_{ef}. [kW]** | **Shielding effectiveness of Cu/Sn coating [dB]** | | | | | **Average surface resistance [Ω]** |
|---|---|---|---|---|---|---|
| | **27.12 MHz** | **97.75 MHz** | **433.92 MHz** | **915 MHz** | **1795 MHz** | |
| 2.0 | 45 | 42 | 38 | 37 | 36 | 2.1 |
| 4.0 | 52 | 50 | 47 | 46 | 44 | 1.62 |

**Table 8**

| **Effective power P_{ef}. [kW]** | **Shielding effectiveness of Cu/Zn/Ni coating [dB]** | | | | | **Average surface resistance [Ω]** |
|---|---|---|---|---|---|---|
| | **27.12 MHz** | **97.75 MHz** | **433.92 MHz** | **915 MHz** | **1795 MHz** | |
| 2.0 | 24 | 22 | 20 | 20 | 19 | 37.45 |
| 4.0 | 32 | 30 | 27 | 27 | 26 | 8.63 |

### Example 7

Thermoplastic PP non-woven fabric 180 g/m² was sputtered with Cu/Sn alloy. Technological conditions of the sputtering method: p = 2.7 • 10⁻³ mbar, P_{ef} = 3.6-3.8 kW, amount of Ar = 4.0%, V = 15 mm/s, number of run cycles = 30. The fabric provided very good barrier against electromagnetic field and Gram (+) and Gram (-) bacteria as well as good air and water vapour permeability.

**Table 9**

| **Coating (Cu/Sn)** | | | | | | |
|---|---|---|---|---|---|---|
| **The barrier effect of the composite against EMF at different frequencies** | | | | | **Air permeability, 200 Pa, mm/s PN-EN 9237:1998** | **Water vapour resistance, Rₑₜ, m²Pa/W PN-EN 31092:1998/Ap 1:2004** |
| Frequency [MHz] | 27.12 | 97.75 | 915 | 1795 | 315 | 9.98 |
| Shielding effectiveness [dB] | 52 | 50 | 46 | 44 | | |
| **Antibacterial activity** | | | | | | |
| **Name of the tested bacteria** (strain number) | ***Staphylococcus aureus*** (ATCC 6538) Gram (+) | | ***Escherichia coli*** (ATCC 11229) Gram (-) | | | |
| Reduction in bacterial growth | **99.99 %** | | **99.99%** | | | |
| * Bactericidal activity value **L** | **3.0** | | **3.0** | | | |
| Measurement method | Luminescent method | | | | | |
| Time and temperature of incubation | 21 h (37±2 °C) | | | | | |

### Example 8 Antifungal activity

Table 10 (below) presents the test results of antifungal activity shown towards *Chaetomium globosum* (ATCC 6205) obtained for three samples comprising polypropylene non-woven fabric coated at the same conditions with different metal alloys (Cu/Zn/Ni, Ni/Cu/Fe and Cu/Sn). In table description, A side is the sputtered side of the sample, while B side is the non-sputtered side of the sample.

**Table 10**

| **Sample identification** | | **Samples side** | **Fungal growth evaluation** | | | | |
|---|---|---|---|---|---|---|---|
| **Type of sputtered fabric** | **Type and composition of the coating** | | **Surface of samples** | | **Surface of agar medium in contact zone with the sample** | | |
| | | | Growth level | Evaluation | Width of the growth inhibition zone [mm] | Growth level | Evaluation |
| PP non-woven fabric | **Cu/Zn/Ni** (53.5-56.5/2530/17-19) | A | 2 | Growth visible without magnifying devices, covering to 25% of the tested surface | 0 | 5 | Strong growth, of the same intensity as the control growth |
| | | B | 0 | Lack of visible growth, evaluated under the microscope (magnification 50x) | 0 | 5 | Strong growth, of the same intensity as the control growth |
| | **Ni/Cu/Fe** (65/33/2) | A | 0 | Lack of visible growth, evaluated under the microscope (magnification 50x) | 0 | 5 | Strong growth, of the same intensity as the control growth |
| | | B | 2 | Growth visible without magnifying devices, covering to 25% of the tested surface | 0 | 5 | Strong growth, of the same intensity as the control growth |
| | **Cu/Sn** (80/20) | A | 0 | Lack of visible growth, evaluated under the microscope (magnification 50x) | 0 | 0 | Lack of visible growth, evaluated under the microscope (magnification 50x) |
| | | B | 0 | Lack of visible growth, evaluated under the microscope (magnification 50x) | 0 | 5 | Strong growth, of the same intensity as the control growth |
| PP non-woven fabric (control sample) | Without coating | A | 2 | Growth visible without magnifying devices, covering to 25% of the control sample surface | 0 | 5 | Strong growth, covering the tested surface under the control sample completely |
| | | B | 4 | Significant growth covering 60% of the control sample surface | 0 | 5 | Strong growth, covering the tested surface under the control sample completely |

Samples of tested non-woven fabrics showed the antifungal activity effect against the tested species of a mould *Chaetomium globosum* (ATCC 6205). In this case, the best antifungal effect was shown by the sample with the coating of the highest copper content, hence the sample with Cu/Sn coating. For this sample no visible microfungal growth was observed under the microscope at the magnification 50x either on the side with the coating (A), or without it (B). No visible growth was also observed under the microscope on the surface of agar medium in contact zone with the sample on the coated side. Other samples (Cu/Zn/Ni, Ni/Cu/Fe) containing smaller amount of copper also showed good antifungal effect, however, somewhat weaker in relation to Cu/Sn sample.

## Claims

1. A method for preparation of a composite textile fabric with bioactive and barrier properties against electromagnetic fields, **characterised in that**:
a) the mechanically cleaned textile substrate is placed on the rolls in the working chamber, where the fabric is rewound from one roll to another, in the reverse method, travelling on the cylindrical anode being a cylindrical segment with a radius of 10 to 30 cm,
b) the textile substrate is cleaned with glow discharge,
c) the functional layer is sputtered in the magnetron sputtering method on the textile substrate travelling on the cylindrical anode at velocity of 5 mm/s to 50 mm/s, wherein as the textile substrate the thermoplastic non-woven fabric of polypropylene or other polyolefin fibres is used, while the functional layer is a metal selected from the group comprising: Cu, Cu/Sn, Cu/Zn/Ni, Zn, ZnO, Ni/Cu/Fe or combinations thereof, and the sputtering of the functional layer on the textile substrate in step c) is repeated in cycles of 5 to 50 times,
wherein the magnetron sputtering is performed continuously at the travelling velocity of the textile substrate on the anode of 15 mm/s,
and the pressure in the working chamber during the magnetron sputtering is within the range of 1.8 • 10⁻³ mbar to 4.0 • 10⁻³ mbar,
and the magnetron sputtering is performed at the effective power ranging from 1.9 kW to 4.06 kW, and the magnetron sputtering is performed at the atmosphere of a working gas, preferably argon, batched to the working chamber at the amount of 3% to 8%,
and the basis weight of the textile substrate is within the range of 50 g/m² to 180 g/m²,
and the fibres of the textile substrate have thickness within the range of 1,89 • 10⁻⁴ g/m to 3,89 • 10⁻⁴ g/m (1.7 den to 3.5 den),
and wherein prior to step a), the textile substrate is calendered and/or spot-welded.

2. The composite textile fabric with bioactive and barrier properties against electromagnetic fields, **characterised in that** it comprises the textile substrate with the functional layer of a thickness from a few to several dozen nanometres sputtered by the magnetron sputtering, wherein the textile substrate is the thermoplastic non-woven fabric of polypropylene or other polyolefin and the basis weight of the textile substrate is within the range of 50 g/m² to 180 g/m² and the fibres of the textile substrate have thickness within the range of 1,88 • 10⁻⁴ g/m to 3,88 • 10⁻⁴ g/m (1.7 den to 3.5 den), while the functional layer is a metal selected from the group comprising: Cu, Cu/Sn, Cu/Zn/Ni, Zn, ZnO, Ni/Cu/Fe or combinations thereof, wherein the said material shows bacteriostatic properties according to JIS L 1902 standard towards to two bacterial strains: Gram (-) *Escherichia coli* and Gram (+) *Staphylococcus aureus,* measured according to ASTM E 2180-07 and AATCC Test Method 100: 2004, and antifungal activity towards mould microfungi: *Chaetomium globosum,* measured according to test procedure No. 8 of 1st edition of PN - EN 14119 : 2005 Standard method B2, and shows the shielding effectiveness SE above 20 dB, measured according to ASTM D-4935-10 Standard, surface resistance below 100 Ω, measured according to PN-EN-1149-1 Standard, air permeability at 200 Pa above 200 mm/s, measured according to PN-EN-ISO 9237:1998 Standard, and water vapour resistance below 10 m²Pa/W, measured according to PN-EN 31092:1998/Apl.2004 Standard.

3. The composite textile fabric according to claim 2, **characterised in that** it is obtained by the method according to claim 1.

4. The composite textile fabric according to any claim from 2 to 3, **characterised in that** the textile substrate is a calendered and/or spot-welded substrate.

## Patentansprüche

1. Verfahren zur Herstellung einer Verbundtextilware mit bioaktiven Eigenschaften und Sperreigenschaften gegenüber elektromagnetischen Feldern, **dadurch gekennzeichnet, dass**:
a) das mechanisch gereinigte Textilsubstrat auf die Rollen in der Arbeitskammer gelegt wird, wobei die Ware im Umkehrverfahren von einer Rolle auf die nächste umgewickelt wird, wobei es sich auf der zylindrischen Anode, bei der es sich um ein zylindrisches Segment mit einem Radius von 10 bis 30 cm handelt, bewegt;
b) das Textilsubstrat mit einer Glimmentladung gereinigt wird;
c) die funktionelle Schicht im Magnetron-Sputterverfahren auf das Textilsubstrat, das sich mit einer Geschwindigkeit von 5 mm/s bis 50 mm/s auf der zylindrischen Anode bewegt, gesputtert wird, wobei als Textilsubstrat ein thermoplastischer Vliesstoff aus Polypropylen oder anderen Polyolefinfasern verwendet wird, während die funktionelle Schicht aus einem Metall besteht, das aus der Gruppe ausgewählt ist, die Cu, Cu/Sn, Cu/Zn/Ni, Zn, ZnO, Ni/Cu/Fe oder Kombinationen davon umfasst, und das Sputtern der funktionellen Schicht auf das Textilsubstrat in Schritt c) zyklisch 5- bis 50-mal wiederholt wird;
wobei das Magnetron-Sputtern kontinuierlich mit der Bewegungsgeschwindigkeit des Textilsubstrats auf der Anode von 15 mm/s durchgeführt wird;
und der Druck in der Arbeitskammer während des Magnetron-Sputterns im Bereich von 1,8.10⁻³ mbar bis 4,0.10⁻³ mbar liegt;
und das Magnetron-Sputtern mit einer effektiven Leistung im Bereich von 1,9 kW bis 4,06 kW durchgeführt wird;
und das Magnetron-Sputtern in einer Atmosphäre aus einem Arbeitsgas, vorzugsweise Argon, das der Arbeitskammer in einer Menge von 3% bis 8% zudosiert wird, durchgeführt wird;
und das Flächengewicht des Textilsubstrats im Bereich von 50 g/m² bis 180 g/m² liegt; und die Fasern des Textilsubstrats eine Dicke im Bereich von 1,89.10⁻⁴ g/m bis 3,89.10⁻⁴ g/m (1,7 den bis 3,5 den) aufweisen;
und wobei das Textilsubstrat vor Schritt a) kalandriert und/oder punktgeschweißt wird.

2. Verbundtextilware mit bioaktiven Eigenschaften und Sperreigenschaften gegenüber elektromagnetischen Feldern, **dadurch gekennzeichnet, dass** sie das Textilsubstrat mit der funktionellen Schicht in einer Dicke von wenigen bis mehreren Dutzend Nanometern, die durch Magnetron-Sputtern aufgesputtert ist, umfasst, wobei das Textilsubstrat ein thermoplastischer Vliesstoff aus Polypropylen oder einem anderen Polyolefin ist und das Flächengewicht des Textilsubstrats im Bereich von 50 g/m² bis 180 g/m² liegt und die Fasern des Textilsubstrats eine Dicke im Bereich von 1,89.10⁻⁴ g/m bis 3,89·10⁻⁴ g/m (1,7 den bis 3,5 den) aufweisen, während die funktionelle Schicht aus einem Metall besteht, das aus der Gruppe ausgewählt ist, die Cu, Cu/Sn, Cu/Zn/Ni, Zn, ZnO, Ni/Cu/Fe oder Kombinationen davon umfasst, wobei das Material Folgendes zeigt: bakteriostatische Eigenschaften gemäß der Norm JIS L 1902 gegenüber zwei Bakterienstämmen: Gram-negativer *Escherichia coli* und Grampositivem *Staphylococcus aureus,* gemessen gemäß ASTM E 2180-07 und dem AATCC-Testverfahren 100: 2004, und eine antimykotische Aktivität gegenüber Schimmelmikropilzen: *Chaetomium globosum,* gemessen gemäß dem Testverfahren Nr. 8 der 1. Ausgabe von PN-EN 14119: 2005 Standardmethode B2, und eine Abschirmeffektivität SE oberhalb von 20 dB, gemessen gemäß der Norm ASTM D-4935-10, einen Oberflächenwiderstand unter 100 Ω, gemessen gemäß der Norm PN-EN-1149-1, eine Luftdurchlässigkeit bei 200 Pa von über 200 mm/s, gemessen gemäß der Norm PN-EN-ISO 9237:1998, und einen Wasserdampfwiderstand unter 10 m²·Pa/W, gemessen gemäß der Norm PN-EN 31092: 1998/Apl. 2004, zeigt.

3. Verbundtextilware gemäß Anspruch 2, **dadurch gekennzeichnet, dass** sie durch das Verfahren gemäß Anspruch 1 erhalten wurde.

4. Verbundtextilware gemäß einem der Ansprüche 2 bis 3, **dadurch gekennzeichnet, dass** das Textilsubstrat ein kalandriertes und/oder punktgeschweißtes Substrat ist.

## Revendications

1. Procédé de préparation d'un tissu en matière textile composite ayant des propriétés bioactives et de barrière contre les champs électromagnétiques, **caractérisé en ce que** :
a) le substrat textile nettoyé mécaniquement est placé sur les rouleaux dans la chambre de travail, où le tissu est enroulé de nouveau d'un rouleau à un autre, selon le procédé inverse, en se déplaçant sur l'anode cylindrique qui est un segment cylindrique avec un rayon de 10 cm à 30 cm,
b) le substrat textile est nettoyé par décharge luminescente,
c) la couche fonctionnelle est pulvérisée au cours du procédé de pulvérisation par magnétron sur le substrat textile se déplaçant sur l'anode cylindrique à une vitesse de 5 mm/s à 50 mm/s, dans lequel le tissu non tissé thermoplastique de polypropylène ou d'autres fibres de polyoléfine est utilisé comme substrat textile, tandis que la couche fonctionnelle est un métal choisi dans le groupe comprenant : Cu, Cu/Sn, Cu/Zn/Ni, Zn, ZnO, Ni/Cu/Fe ou des combinaisons de ceux-ci, et la pulvérisation de la couche fonctionnelle sur le substrat textile à l'étape c) est répétée en cycles de 5 à 50 fois,
dans lequel la pulvérisation par magnétron est réalisée en continu à la vitesse de déplacement du substrat textile sur l'anode de 15 mm/s,
et la pression dans la chambre de travail pendant la pulvérisation par magnétron se situe dans la plage de 1,8 • 10⁻³ mbar à 4,0 • 10⁻³ mbar,
et la pulvérisation par magnétron est réalisée à la puissance effective allant de 1,9 kW à 4,06 kW,
et la pulvérisation par magnétron est réalisée sous l'atmosphère d'un gaz de travail, de préférence l'argon, dosé dans la chambre de travail en une quantité de 3 % à 8 %,
et le poids de base du substrat textile se situe dans la plage de 50 g/m² à 180 g/m²,
et les fibres du substrat textile ont une épaisseur dans la plage de 1,89 • 10⁻⁴ g/m à 3,89 • 10⁻⁴g/m (1,7 den à 3,5 den),
et dans lequel avant l'étape a), le substrat textile est calandré et/ou soudé par points.

2. Tissu en matière textile composite ayant des propriétés bioactives et de barrière contre les champs électromagnétiques, **caractérisé en ce qu'**il comprend le substrat textile dont la couche fonctionnelle d'une épaisseur de quelques nanomètres à plusieurs dizaines de nanomètres est pulvérisée par la pulvérisation par magnétron, dans lequel le substrat textile est le tissu non tissé thermoplastique de polypropylène ou d'une autre polyoléfine, et le poids de base du substrat textile se situe dans la plage de 50 g/m² à 180 g/m² et les fibres du substrat textile ont une épaisseur dans la plage de 1,88 • 10⁻⁴ g/m à 3,88 • 10⁻⁴ g/m (1,7 den à 3,5 den), tandis que la couche fonctionnelle est un métal choisi dans le groupe comprenant: Cu, Cu/Sn, Cu/Zn/Ni, Zn, ZnO, Ni/Cu/Fe ou des combinaisons de ceux-ci, dans lequel ledit matériau présente des propriétés bactériostatiques selon la norme JIS L 1902 vis-à-vis de deux souches bactériennes : Gram (-) Escherichia coli et Gram (+) Staphylococcus aureus, mesurées selon le procédé d'essai 100 ASTM E2180-07 et AATCC : 2004, et une activité antifongique vis-à-vis des microchampignons de moisissure : Chaetomium giobosum, mesurée selon la procédure d'essai n°8 de la 1^{re} édition du procédé B2 de la norme PN-EN 14119 : 2005, et présente une efficacité de blindage SE au-dessus de 20 dB, mesurée selon la norme ASTM D-4935-10, une résistance de surface en dessous de 100 Ω, mesurée selon la norme PN-EN-1149-1, une perméabilité à l'air à 200 Pa au-dessus de 200 mm/s, mesurée selon la norme PN-EN-ISO 9237 : 1998, et une résistance à la vapeur d'eau en dessous de 10 m²Pa/W, mesurée selon la norme PN-EN 31092 : 1998/Apl.2004.

3. Tissu en matière textile composite selon la revendication 2, **caractérisé en ce qu'**il est obtenu par le procédé selon la revendication 1.

4. Tissu en matière textile composite selon l'une quelconque des revendications 2 à 3, **caractérisé en ce que** le substrat textile est un substrat calandré et/ou soudé par points.
